# Europäisches Patentamt
# European Patent Office
# Office européen des brevets

(19)

(11) Veröffentlichungsnummer: **0 183 117**
**B1**

(12) # EUROPÄISCHE PATENTSCHRIFT

(45) Veröffentlichungstag der Patentschrift:
06.04.88

(51) Int. Cl.⁴: **B 23 Q 7/18**, B 23 P 21/00

(21) Anmeldenummer: **85114312.3**

(22) Anmeldetag: **11.11.85**

(54) Positioniervorrichtung für Werkstücke auf einem Tragelement.

(30) Priorität: **29.11.84 DE 3443548**

(43) Veröffentlichungstag der Anmeldung:
**04.06.86 Patentblatt 86/23**

(45) Bekanntmachung des Hinweises auf die Patenterteilung:
**06.04.88 Patentblatt 88/14**

(84) Benannte Vertragsstaaten:
**AT BE CH DE FR GB IT LI LU NL SE**

(56) Entgegenhaltungen:
**US-A-4 035 899**
**US-A-4 209 898**

(73) Patentinhaber: **Montech AG, Gewerbestrasse 12, CH- 4552 Derendingen (CH)**

(72) Erfinder: **Trenner, Albrecht Heinz, Kronmattstrasse 15, CH- 4513 Langendorf (CH)**
Erfinder: **Wirz, Herbert, Grederstrasse 16 D, CH- 4512 Bellach (CH)**

(74) Vertreter: **Weiss, Peter, Schlachthausstrasse 1 Postfach 466, D-7700 Singen a.H. (DE)**

EP 0 183 117 B1

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

LIBER, STOCKHOLM 1988

## Beschreibung

Die vorliegende Erfindung bezieht sich auf eine Positioniervorrichtung für Werkstücke, die auf plattenförmigen Tragelementen aufgenommen sind, mit einem Förderband, welches entlang eines Stützorganes umläuft und die Tragelemente mit den Werkstücken zu einer Zentriervorrichtung hin und von dieser wegbewegt.

Ein bevorzugtes Anwendungsgebiet der Vorrichtung gemäss der vorliegenden Erfindung ist in der möglichst weitgehend mechanischen Handhabung von im allgemeinen vergleichsweise kleinen Werkstücken zu sehen, die zum Beispiel von einem Vorratslager, einem Magazin oder dgl. zu einer Behandlungsstelle oder von einer Behandlungsstelle zu einer nachfolgenden Behandlungsstelle gebracht werden müssen, um dort in irgend einer Weise einer mechanischen Behandlung oder Bearbeitung unterzogen zu werden. Die Behandlungsstelle kann einen mechanischen Greifer umfassen, der die zugeführten Werkstücke erfasst und einer nachgeordneten Bearbeitungsstelle bzw. die Werkstücke als Einzelteile einem Montageprozess zuführt, oder aber die Werkstücke können an der Behandlungsstelle weiterbearbeitet, durch zusätzliche Teile ergänzt oder sonst irgendwie bearbeitet werden. Zu diesem Zweck sind die einzelnen Werkstücke in Werkstück-Tragelementen angeordnet, die auf einem Förderband den einzelnen Behandlungsstellen zugeführt werden.

Jedenfalls ist es aber erforderlich, dass die zu behandelnden bzw. zu bearbeitenden Werkstücke in einer genau definierten Position innerhalb der Behandlungsstelle zur Verfügung stehen. Da die Werkstücke bezüglich des Tragelementes fest und unverrückbar, in genau bekannter Lage und Ausrichtung, gehalten sind, und da das Tragelement bezüglich seiner Dimensionen bekannt ist, kann diesen Erfordernissen dadurch Genüge getan werden, dass das Tragelement mit der im Einzelfall festzulegenden Präzision innerhalb der Behandlungsstelle positioniert wird. Dabei ist, besonders wenn es sich um kleine Werkstücke handelt, unter Umständen eine ausserordentlich hohe Präzision bezüglich der erwünschten Lage zu einzuhalten. Schon das Erreichen der erwünschten Soll-Lage allein ist nicht einfach zu bewerkstelligen; wenn zudem eine hohe Arbeitsgeschwindigkeit, d.h. eine hohe Fördergeschwindigkeit zu den Behandlungsstellen hin und von diesen weg, gefordert wird, vergrössern sich die Probleme weiter.

Es ist die Aufgabe der vorliegenden Erfindung, hier Abhilfe zu schaffen und eine Positioniervorrichtung der eingangs erwähnten Art vorzuschlagen, welche es erlaubt, Werkstücke, die auf Tragelementen aufgenommen sind und die mit einem Förderband, welches entlang eines Stützorganes umläuft und die Tragelemente mit den Werkstücken transportiert, mit hoher Geschwindigkeit einer Behandlungsstelle zuzuführen, welche eine Zentriervorrichtung aufweist, die die Tragelemente und damit die zu bearbeitenden bzw. zu behandelnden Werkstücke mit höchster Präzision in eine vorbestimmte Soll-Lage bringt.

Gemäss der vorliegenden Erfindung wird diese Aufgabe mit einer Vorrichtung der eingangs erwähnten Art gelöst, die die Merkmale des Anspruchs 1 aufweist.

Damit lässt sich zunächst einmal erreichen, dass das Tragelement in den zwei wichtigsten Richtungen positioniert ist, nämlich zum einen unter Wirkung der beiden Anschlagorgane am Tragelement in Zusammenarbeit mit der Anschlagfläche am einen der Zentrierelemente in Richtung senkrecht zur Förderung des Bandes (seitliche Positionierung) und zum anderen in Längsrichtung des Förderbandes (absolute Wegpositionierung), dies unter Wirkung der Zusammenarbeit zwischen dem Zentrierorgan am Tragelement und dem korrespondierend ausgebildeten Zentrierorgan am anderen der Zentrierelemente der Zentrierstation, das Ganze unter Ausnutzung der relativen Verschieblichkeit der Zentrierelemente gegenüber dem Förderband und damit dem Tragelement.

Eine erste Ausführungsform der erfindungsgemässem Vorrichtung kann sich dadurch auszeichnen, dass der rechteckige, Teil an einer Seitenfläche im Bereich wenigstens zweier benachbarter Ecken mit Anschlagorganen ausgerüstet ist. Somit eignet sich das Tragelement zur Förderung durch das Förderband in einer Richtung, indem die beiden Anschlagorgane in den Ecken entlang einer zur Förderrichtung parallelen Seitenkante angebracht sind.

Wenn das Tragelement jedoch im Verlauf seiner Förderung um 90 grad umgelenkt wird, ist es zweckmässig, wenn der plattenförmige Teil im Bereich von drei Ecken mit Anschlagorganen ausgerüstet ist. Jeweils zwei dieser Anschlagorgane bewirken dann, in Zusammenarbeit mit entsprechend angeordneten Anschlagflächen, die seitliche Zentrierung des Tragelementes und damit des darauf angeordneten Werkstückes. Jedenfalls ist es zweckmässig, wenn die Anschlagorgane durch zylindrische Zapfen gebildet sind, deren Mantelflächen teilweise über die Seitenkante des plattenförmigen Teils hinausragen, da zylinderförmige Elemente leicht mit ausserordentlich hoher Präzision herstellbar sind.

Das Zentrierorgan kann durch einen am plattenförmigen Teil angebrachten, zumindest teilweise eine kegelmantelförmige Oberfläche aufweisenden Zentrierzapfen gebildet sein, welcher seitlich abstehend an der Seitenfläche des plattenförmigen Teiles angebracht ist. Auch dieses Teil lässt sich leicht mit der erforderlichen Präzision herstellen und gewährleistet durch die kegelige Oberfläche, in Zusammenarbeit mit dem Zentrierorgan an der Zentrierstation, eine zwangsläufige Positionierung des Tragelementes in Längsrichtung.

Wenn, wie vorher erwähnt, eine Umlenkung der Bewegungsbahn der Tragelemente um 90 grad vorgesehen ist, kann es zweckmässig sein, wenn zwei benachbarte Seitenflächen des Tragelementes mit je einem solchen Zentrierorgan versehen sind.

Bei einer bevorzugten Ausführungsform ist dabei vorgesehen, dass das bzw. die Zentrierorgane des Tragelementes jeweils in der Mitte einer Seitenfläche des plattenförmigen Teils des Tragelementes angeordnet ist bzw. sind. Diese Massnahme vereinfacht die Dimensionierung der einzelnen Bauteile der Vorrichtung und macht sie universeller verwendbar.

Was die Ausbildung der Zentrierstation anbetrifft, ist es zweckmässig, wenn diese zwei etwa parallel und im Abstand zueinander angeordnete, beidseitig des Förderbandes liegende Zentrierbacken aufweist, die je einen ersten, sich im wesentlichen vertikal erstreckenden Teil sowie je einen zweiten, sich im wesentlichen horizontal erstreckenden, am oberen Ende des ersten Teils lösbar angebrachten Teil umfassen.

Vorzugsweise umfasst die Zentrierstation ein stationäres Gestell, welches auf festem Untergrund aufliegt und an welchem die beiden Zentrierbacken in vertikaler Richtung verschiebbar gelagert sind. Die Anschlagfläche für die Anschlagorgane des Tragelementes kann dabei durch eine gegen das ebenfalls fest abgestützte Förderband gerichtete Stirnfläche des sich horizontal erstreckenden Teils des einen Zentrierbackens gebildet sein.

Zur gleichzeitigen Längs- und Querzentrierung des Tragelementes kann der zweite Zentrierbacken mit zwei an seinem sich horizontal erstreckenden Teil angebrachten, gegen unten vorstehenden, eine im wesentlichen kegelmantelförmige Oberfläche aufweisenden Zentrierzapfen versehen ist. Diese beiden Zapfen übergreifen dabei den am Tragelement angeordneten Zentrierzapfen, indem die jeweiligen konischen Oberflächen aneinander angreifen, sodass das Tragelement in seine Soll-Position verschoben und die Anschlagorgane gegen die Anschlagfläche verschoben wird bzw. werden.

Das Stützorgan für das Förderband ist vorzugsweise im Bereich der Zentrierstation mit sich längsseits des Förderbandes beidseitig erstreckenden Durchbrechungen versehen. Dies schafft die Möglichkeit, dass am stationären Gestell beidseitig des Förderbandes je im Bereich der beiden Durchbrechungen angeordnete Stützteile durch diese Durchbrechungen hindurchtreten können, um mit ihrer gegen oben gerichteten Stirnfläche eine Auflagefläche für ein Tragelement zu bilden und so eine definierte Lage des Tragelementes auch in Bezug auf die Höhe desselben zu gewährleisten.

Ausserdem können die beiden Zentrierbacken je einen im Bereich der beiden Durchbrechungen angeordneten, unter dem Förderband liegenden Gleitschuh aufweisen, dessen obere Stirnflächen, bei einer vertikalen Verschiebung der Zentrierbacken gegen oben, gegen die Unterseite des Förderbandes aufliegen und somit dieses von der Oberfläche dessen Stützorganes abheben. Dadurch ist das Tragelement von den zuvor genannten Auflageflächen entkoppelt und kann mittels des Förderbandes bewegt werden. Bei einem Rückzug der Gleitbacken legt sich das Förderband aber auf die Oberfläche seines Stützorganes auf, die Unterseite des Tragelementes löst sich von der Oberfläche des Förderbandes und wird somit nicht mehr gefördert, und das Tragelement kommt auf den genannten Auflageflächen zur Ruhe. Der Zweck ist der, dass das Band beim Klemmen des Tragelementes frei unter diesem hindurchlaufen kann.

Um für das vom Förderband bewegte Tragelement, das das zu bearbeitende oder zu behandelnde Werkstück trägt, einen Anschlag zu schaffen, der das Tragelement innerhalb der Zentrierstation mindestens annähernd in der richtigen Lage anhält, bevor das Förderband vom Tragelement entkoppelt wird, kann mindestens eines der beiden Zentrierelemente der Zentrierstation mit einem Hemmorgan versehen ist, welches von einer ausserhalb der Bewegungsbahn eines Tragelementes liegenden Ruhelage in eine in die Bewegungsbahn des Tragelementes ragende Wirklage bringbar ist. Dieses Hemmorgan ist zweckmässigerweise durch eine schwenkbar am einen Zentrierbacken gelagerte, durch einen pneumatischen Zylinder betätigbare Klinke gebildet, die einerends einen in die Bewegungsbahn des Tragelementes verschwenkbaren Fortsatz trägt.

Um unter anderem beim Anschlagen des Tragelementes an die Klinke das Förderband auszukuppeln und den eigentlichen Bearbeitungsvorgang einzuleiten, kann zumindest einer der Zentrierbacken mit einem die Anwesenheit und/oder die Position eines Tragelementes zwischen den beiden Zentrierbacken abtastenden Schaltorgan, vorzugsweise einem induktiven Näherungsschalter, versehen sein.

Im folgenden wird ein Ausführungsbeispiel der erfindungsgemässen Positioniervorrichtung, unter Bezugnahme auf die beiliegenden Zeichnungen, näher erläutert. In den Zeichnungen zeigen:

Fig. 1 eine schematische Seitenansicht der gesamten Anordnung,

Fig. 2 eine schematische Ansicht der Anordnung gemäss Figur 1 von oben,

Fig. 3 eine teilweise geschnittene Ansicht der Zentrierstation in Richtung des Pfeiles I in Figur 1, bei der die Zentrierstation in Ruhelage ist,

Fig. 4 eine Ansicht entsprechend Figur 3, bei der aber die Zentrierstation in Wirklage ist,

Fig. 5 eine teilweise geschnittene Ansicht der Zentrierstation von der Seite her,

Fig. 6 eine Ansicht der Zentrierstation von oben her,

Fig. 7 eine Detailansicht der einen Seite der Zentrierstation in Richtung des Pfeiles VII in Figur 6,

Fig. 8 eine Ansicht eines Tragelementes von oben,

Fig. 9 eine Seitenansicht des Tragelementes von Figur 8 in Richtung des Pfeiles IX, und

Fig. 10 eine Seitenansicht des Tragelementes von Figur 8 in Richtung des Pfeiles X.

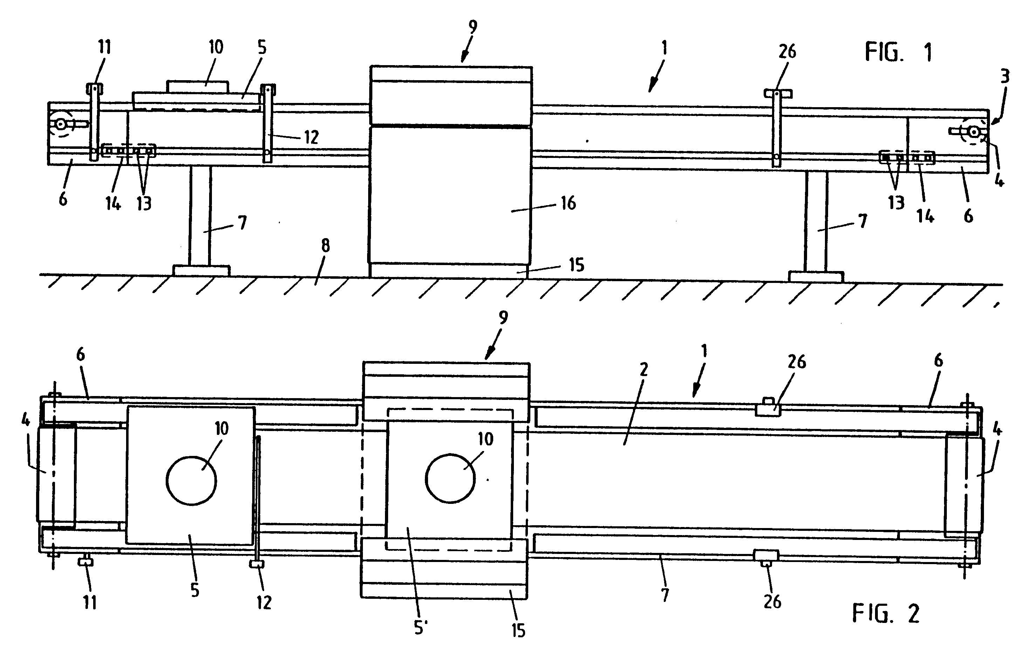

In den Figuren 1 und 2 ist ein Förderband-Abschnitt 1 dargestellt, der Teil einer Förderanlage zum Transport von Werkstückträgern 5 bilden mag. Der Förderband-Abschnitt 1 umfasst das eigentliche Förderband 2, welches entlang eines Stützorganes 3 umläuft. Zu diesem Zwecke sind am Ende des Stützorganes 3 Endabschnitte 6 vorgesehen, die je eine Umlenkrolle 4 zur Führung des Förderbandes 2 tragen. Die Endabschnitte 6 können mittels Verbindungslaschen 14 am zentralen Abschnitt des Stützorganes 3 befestigt und mittels Schrauben 13 arretiert sein. Selbstverständlich sind zum Antrieb des Bandes geeignete Antriebsmittel vorhanden, die jedoch in den Figuren 1 und 2 nicht dargestellt sind.

Das Stutzorgan 3 für das Förderband 2 ist mittels Trägern 7 auf einer festen Unterlage 8, zweckmässigerweise in der Höhe einstellbar, abgestützt.

Der Förderband-Abschnitt 1 ist mit einer generell mit 9 bezeichneten Zentrierstation versehen. Diese hat in erster Linie die Aufgabe, einen darin befindlichen Werkstückträger 5' und damit das auf diesem befindliche Werkstück 10 in eine genau definierte Soll-Lage zu bringen, damit das Werkstück, wie einleitend erwähnt, entweder vom Werkstückträger 5' entnommen und einer Weiterverarbeitung zugeführt werden kann oder aber, während seines Verbleibens auf dem Werkstückträger 5', irgendeiner Weiterbehandlung oder -bearbeitung unterzogen werden kann. Dazu sind in den Zeichnungen nicht dargestellte, an sich bekannte Manipulationsorgane vorgesehen, die im Bereich der Zentrierstation 9 angeordnet sind.

Im übrigen umfasst die in den Figuren 1 und 2 dargestellte Anordnung Sensoren 11 zur Erfassung eines durchlaufenden Werkstückträgers 5, eine Stauvorrichtung 12, die die Aufgabe hat, einen Werkstückträger 5 in einer Bereitschaftslage aufzuhalten, währenddem sich ein Werkstückträger 5 innerhalb der Zentrierstation 9 befindet, und Sensoren 26 zur Kontrolle des ordnungsgemässen Verlassens der Zentrierstation 9. Es versteht sich, dass die Anordnung und Ausbildung dieser Sensoren und auch der Stauvorrichtung 12 vom einzelnen Anwendungsfall abhängt und in den Figuren 1 und 2 nur rein exemplarisch angedeutet ist.

Im weiteren sei vorausgesetzt, dass ausserdem ein ebenfalls nicht näher dargestelltes Steuergerät vorgesehen ist, welches die Bewegung des Förderbandes 2 sowie die Funktion der Zentriervorrichtung 9 beeinflusst, wobei die Sensoren 11 und 26 sowie weitere nicht näher dargestellte bzw. im folgenden noch zu erläuternde Befehlsgeber an dieses Steuergerät angeschlossen sind. Zweckmässigerweise kann dazu dasselbe Steuergerät verwendet werden, welches auch den Bewegungsablauf der im Bereich der Zentrierstation 9 angeordneten Werkstück-Manipuliervorrichtung steuert. Hierauf braucht nicht weiter eingegangen zu werden, da die Auswahl eines zweckmässigen Steuergerätes in Ermessen des mit der Materie vertrauten Fachmannes liegt.

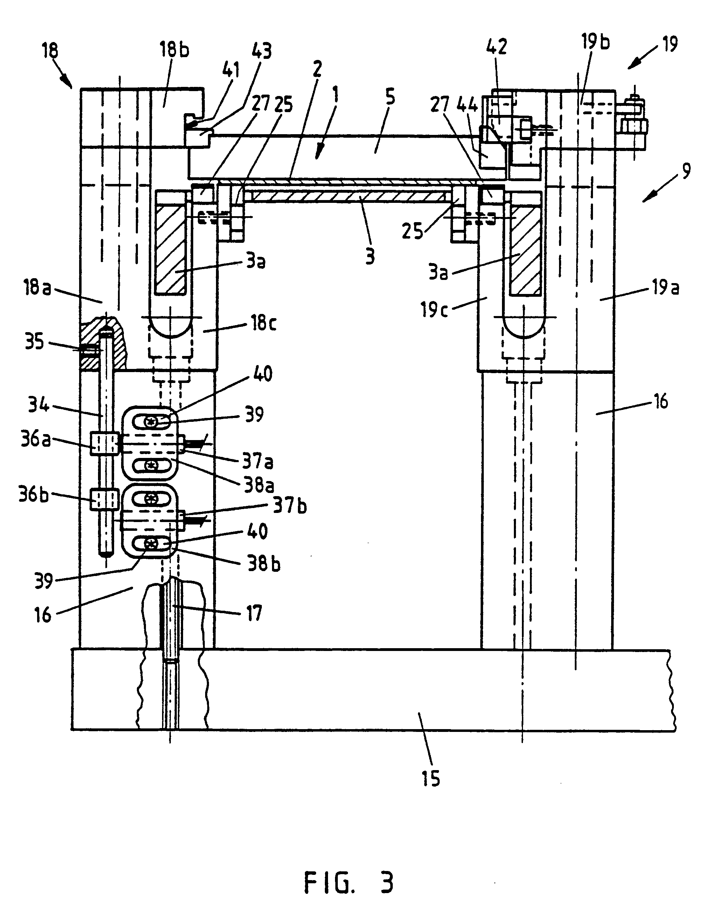

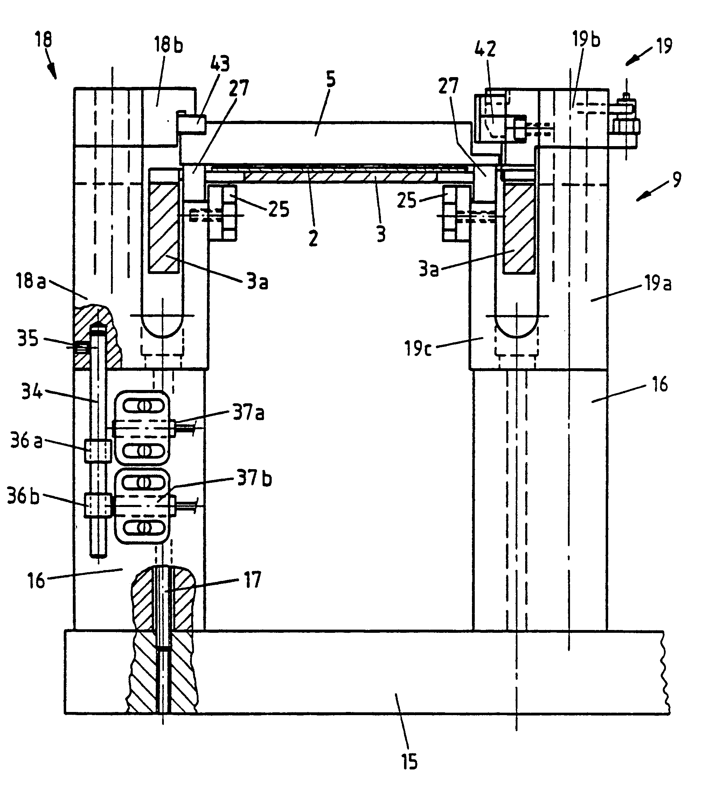

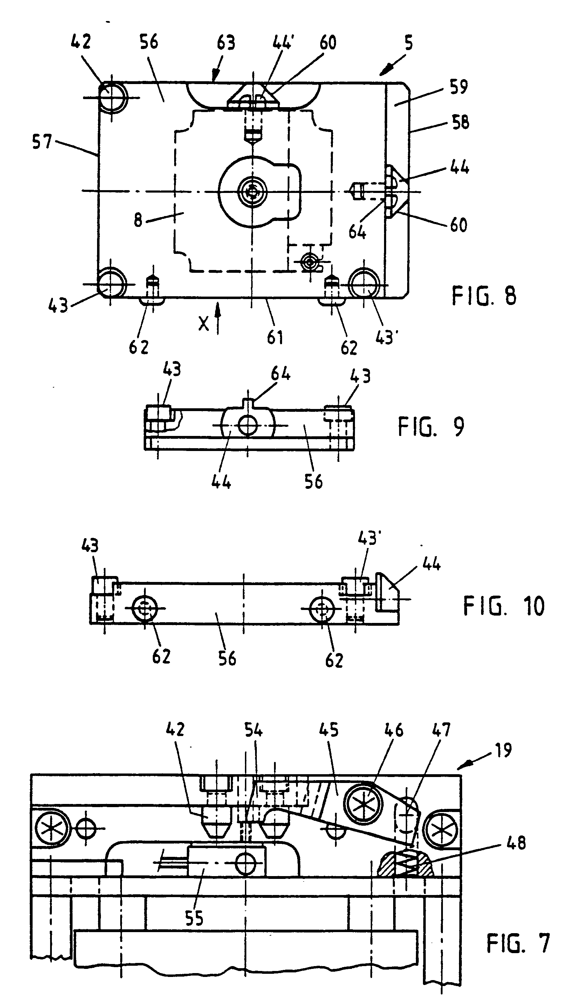

Im folgenden wird der strukturelle Aufbau der Zentrierstation 9, die mit dem Werkstückträger 5 zusammenarbeitet, anhand der Darstellungen in den Fig. 3 bzw. 4 und den Fig. 5 bis 7 näher erläutert. Auf die Ausbildung des Werkstückträgers wird anschliessend anhand der Darstellungen in den Fig. 8 bis 10 eingegangen werden, während schliesslich die Arbeitsweise der Vorrichtung, insbesondere anhand der Fig. 3 und 4, erläutert werden wird.

Die Zentrierstation 9 umfasst eine Grundplatte 15, die auf der stationären Unterlage 8 aufliegt und dort gegebenenfalls fest verankert, z.B. verschraubt ist. Die Grundplatte 15 bildet Teil eines stationären Gestells, welches ausserdem die Träger 16 umfasst. Diese sind mittels Verankerungsbolzen 17 mit der Grundplatte 15 verbunden. Die gesamte Anordnung von Grundplatte 15 und Trägern 16 ist in etwa U-förmig, wobei der gegenseitige Abstand der beiden Träger 16 an die Breite des Stützorganes 3 für das Förderband 2 angepasst ist.

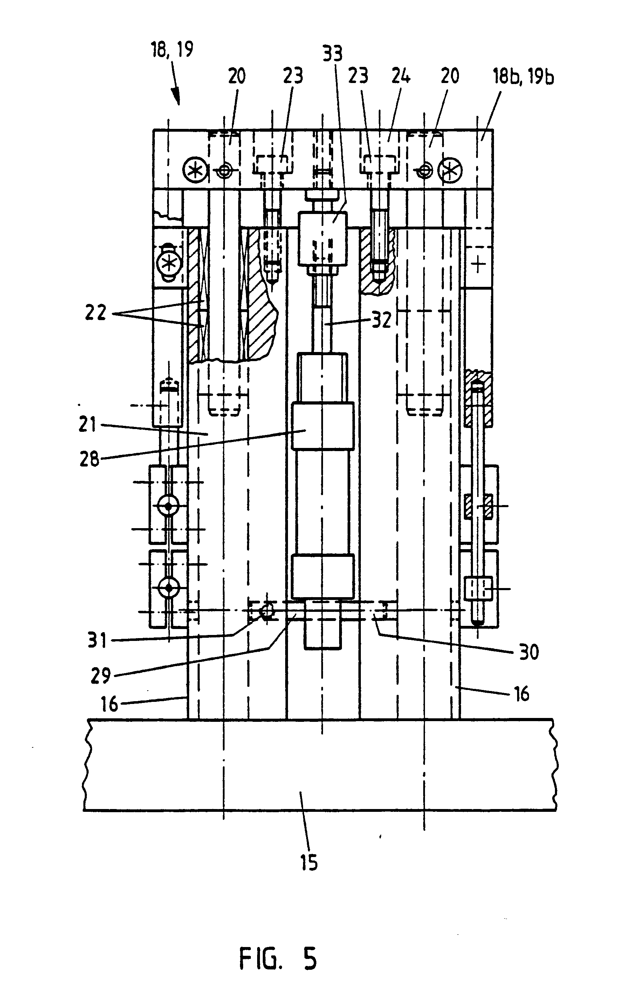

Jeder der beiden Träger 16 bzw. der Trägerpaare je einer Seite der Zentrierstation 9 nimmt je eine erste, gesamthaft mit 18 bezeichnete Zentrierbacke und je eine zweite, gesamthaft mit 19 bezeichnete Zentrierbacke auf. Die beiden Zentrierbacken 18 und 19 sind gegenüber den Trägern 16 in der Höhe verschiebbar gelagert; wie aus der Figur 5 entnommen werden kann, umfasst jede der Zentrierbacken 18, 19 zwei im Abstand voneinander angeordnete, sich nach unten erstreckende Führungsstangen 20, die in einer Bohrung 21 in den zugeordneten Trägern 16 aufgenommen sind. Zur Führung der Stangen 20 und damit der Backen 18 und 19 sind in die Bohrungen 21 Führungsbüchsen 22 eingesetzt. Anschlagschrauben 23, deren Schäfte in die Träger 16 eingeschraubt sind, begrenzen mit ihrem Kopf die Bewegung der Backen 18 und 19, indem die untere Stirnfläche des Kopfes der Anschlagschrauben 23 gegen den Grund von in den Backen 18 und 19 vorgesehenen Sackbohrungen stösst.

Jede der Zentrierbacken 18 und 19 umfasst einen ersten, sich im wesentlichen vertikal erstreckenden Teil 18a bzw. 19a sowie einen zweiten, sich im wesentlichen horizontal erstreckenden Teil 18b bzw. 19b. Die Teile 18a bzw. 19a sind mit einem gegen oben abstehenden Fortsatz 18c bzw. 19c ausgerüstet; diese Fortsätze verlaufen parallel zu den vertikalen Teilen 18a bzw. 19a und im Abstand dazu. Zwischen den Teilen 18a und 19a ist der Förderband-Abschnitt 1 derart aufgenommen, dass sich die beiden seitlichen Schenkel 3a des Stützteiles 3 in den Zwischenraum zwischen den vertikalen Teilen 18a bzw. 19a und den Fortsätzen 18c bzw. 19c hinein erstreckt. In diesem Zusammenhang sei daran erinnert, dass das Stützorgan 3 durch die Träger 7 abgestützt ist, somit in keiner unmittelbaren Verbindung mit der Zentrierstation 9 steht.

Die oberen Enden der vertikalen Fortsätze 18c bzw. 19c sind mit Gleitschuhen 25 versehen, die vorzugsweise aus einem Kunststoff mit niedrigem Reibungskoeffizienten, wie z.B. Nylon oder Teflon, gefertigt sind. Diese Gleitschuhe 25 erstrecken sich über das obere Ende der Fortsätze 18c bzw. 19c hinaus. Das Stützorgan 3 ist mit seitlichen, längsverlaufenden Ausnehmungen versehen, durch welche sich die genannten Gleitschuhe 25 erstrecken. Damit sind die Gleitschuhe 25 befähigt, mit ihrer Oberfläche gegen die Unterseite des Förderbandes 2 aufzuliegen, wie es in Figur 3 dargestellt ist. Der Sinn und Zweck dieser Massnahme wurde schon eingangs angedeutet und wird im folgenden noch näher erklärt werden.

Ferner sind die Träger 16 mit sich ebenfalls nach oben erstreckenden Fortsätzen 27 versehen, die somit nicht höhenverstellbar sind und die sich auch durch die Ausnehmungen im Stützorgan 3 hindurch erstrecken. Die obere Stirnfläche dieser Fortsätze 27 dient dabei als Auflagefläche für einen Werkstückträger 5'; auch dies wird im folgenden noch eingehender erläutert werden.

Wie schon erwähnt, sind die Zentrierbacken 18 und 19 gegenüber dem durch die Grundplatte 15 und den Trägern 16 gebildeten, ortsfesten Gestell höhenverschieblich. Zu diesem Zweck ist auf beiden Seiten der Zentrierstation 9 je ein pneumatischer Zylinder 28 vorgesehen, dessen Unterseite mittels eines Querbolzens 29 an den beiden jeweiligen Trägern 16 abgestützt ist. Der Querbolzen findet in Bohrungen 30 der Träger 16 Aufnahme und eine Arretierschraube 31 sichert den Bolzen 29 gegen Verschiebung. Die sich aus den Zylindern 28 nach oben hinaus erstreckenden Kolbenstangen 32 sind über je ein Entkoppelungsglied 33 mit der zugeordneten Zentrierbacke 18 bzw. 19 verbunden, indem sie mit deren querverlaufenden, sich im wesentlichen horizontal erstreckenden Teilen 18b bzw. 19b verschraubt sind. Das Entkoppelungsglied schafft eine kraftschlüssige, jedoch nicht formschlüssige Verbindung zwischen Kolbenstange 32 und Zentrierbacke 18 bzw. 19, enthebt also von der Notwendigkeit, die pneumatischen Zylinder 28 mit grosser Präzision auszurichten anzuordnen. Nicht dargestellte Mittel versorgen die Zylinder 28 mit Druckluft, wobei deren Zufuhr zweckmässigerweise unter Einfluss des zuvor erwähnten, gemeinsamen Steuerorganes steht.

Aus den Figuren 3 und 4 geht hervor, dass zur Steuerung bzw. Positionserkennung der Zentrierbacken 18 bzw. 19 Steuerorgane vorhanden sind, nämlich zum einen eine sich vertikal nach unten erstreckende Steuerstange 34, die in den Teilen 18a bzw. 19a der Zentrierbacken 18 bzw. 19 verankert und mit einer Klemmschraube 35 festgehalten ist. Auf dieser Stange 34 sind zwei zweckmässigerweise verschiebbar gelagerte Hülsen 36a und 36b angeordnet, die mit induktiven Schaltern 37a und 37b zusammenarbeiten. Letztere sind mit ihren Grundplatten 38a und 38b an den Säulen 16 befestigt, wobei zur Lageeinstellung Schrauben 39 dienen, die Schlitze 40 in der Grundplatte 38 durchgreifen. Die Anordnung ist dabei so getroffen, dass in der Ruhelage gemäss Figur 3, bei welcher sich die beiden Zentrierbacken 18 und 19 in ihrer oberen Endlage befinden, die Hülse 36a direkt vor dem Schalter 37a liegt, so dass dieser aktiviert ist und ein entsprechendes Signal an das Steuergerät liefert. Wenn die Zentrierbacken 18 und 19 hingegen in ihrer unteren Endstellung sind, wie dies aus Figur 4 ersichtlich ist, befindet sich die Hülse 36b vor dem Schalter 37b, so dass dieser ein Signal an das Steuergerät liefert, welches diesem das Erreichen der unteren Endstellung mitteilt. Dabei ist in der Position gemäss Figur 3 der Schalter 37b, in der Position gemäss Figur 4 der Schalter 37a ausser Funktion, da die zugeordnete Hülse 36b bzw. 36a ausserhalb des Wirkungsbereiches auf den jeweiligen Schalter liegt.

Aus den Figuren 3 und 4 geht weiter hervor, dass der Teil 18b der ersten Zentrierbacke 18 eine sich vertikal und parallel zur Förderrichtung des Förderbandes 2 erstreckende Anschlagfläche 41 aufweist. Die zweite Zentrierbacke 19 hingegen ist mit zwei im Abstand zueinander angeordneten Zentrierzapfen 42 versehen, die, wie am besten aus Figur 7 ersichtlich ist, einen gegen unten abstehenden, kegeligen Endbereich aufweisen. Wie aus den Figuren 3 und 4 zu sehen und im folgenden noch näher zu erläutern ist, arbeiten einerseits Anschlagorgane 43 des Tragelementes 5 mit der Anschlagfläche 41 und andererseits ein Zentrierorgan 44 des Tragelementes 5 mit den Zentrierzapfen 42 an der Zentrierbacke 19 zusammen. Die in Figur 3 dargestellte Lage entspricht dabei dem Zustand zum Zeitpunkt, wo das Tragelement 5 in die Zentrierstation 9 einfährt, währenddem die in Figur 4 gezeigte Lage dem Zustand entspricht, wo das Tragelement 5 festgehalten und in der Zentrierstation 9 zentriert ist.

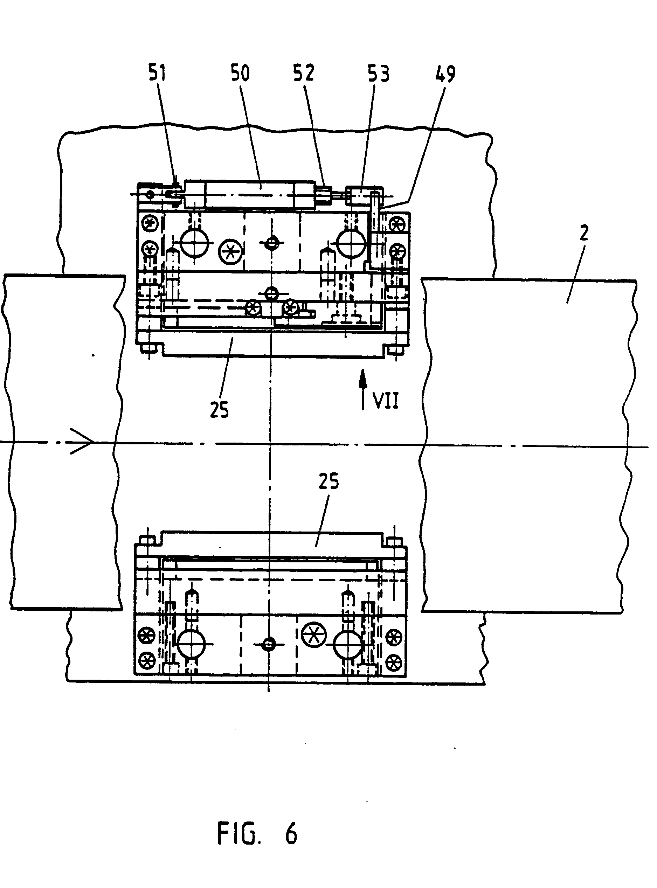

Aus der Figur 7 ist zu sehen, dass die zweite Zentrierbacke 19 eine Klinke 45 aufweist, die auf einer Welle 46 schwenkbar gelagert ist. Der kürzere Hebelarm 47 der Klinke 45 stützt sich mit seinem freien Ende gegen eine Feder 48 ab und ist über eine Gestängeanordnung 49 (Figur 6) mit einem Betätigungszylinder 50 verbunden. Dieser ist einerseits über ein Schwenkglied 51 an der Aussenseite der Zentrierbacke 19 gelagert und andererseits mit seiner Kolbenstange 52 über ein Kopplungsorgan 53 an die Gestängeanordnung 49 angeschlossen. Eine Betätigung des Zylinders 50, zweckmässigerweise ebenfalls unter Wirkung des schon mehrfach erwähnten Steuergerätes, bewirkt eine Verschwenkung der Klinke 45 um die Welle 46.

Der längere Hebelarm der Klinke 45 besitzt ein Endstück 54, welches bei betätigter Klinke in die Bewegungsbahn eines Tragelementes 5 hineinragt und somit einen Anschlag bildet, welcher verhindert, dass das Tragelement 5 weitergefördert wird. Die Anwesenheit eines Tragelementes 5 in der Zentrierstation 9 wird dabei von einem induktiven Schalter 55 erkannt, der ebenfalls an das erwähnte Steuergerät angeschlossen ist und der diesem den Befehl gibt, den eigentlichen Zentriervorgang einzuleiten, d.h. die Zentrierbacken 18 und 19 abzusenken. Es versteht sich dabei, dass das Endstück 54 lediglich die Aufgabe hat, das Tragelement 5 innerhalb der Zentrierstation 9 grob zu positionieren.

Aus den Figuren 8 bis 10 ist die Ausbildung des Tragelementes ersichtlich, das im vorliegenden Ausführungsbeispiel die Gestalt eines plattenförmigen Werkstückträgers 5 besitzt. Dieser wird durch eine etwa rechteckige Grundplatte 56, z.B. aus Aluminium oder dgl., gebildet und nimmt ein in Figur 8 gestrichelt angedeutetes Werkstück 8 auf, das auf der Oberfläche der Platte fixiert ist. An den Enden der Seitenkante 57, d.h. im Bereich zweier Ecken der Platte 56, sind zapfenförmige Anschlagorgane 43 montiert, die mit ihren zylindrischen Seitenflächen etwas über die Seitenkante 57 hervorstehen. Die Zapfen 43 sind vorzugsweise präzisionsgeschliffene Stahlelemente. Auf der gegenüberliegenden Seitenkante 58 ist ein Absatz 59 ausgebildet, im Bereich dessen Mitte das Zentrierorgan 44 angebracht ist. Dieses besitzt einen kegeligen Oberflächenbereich 60, der mit den beiden Zentrierzapfen 42 (Figur 7) zusammenarbeitet. Das Tragelement 5 bewegt sich dabei in Richtung des Pfeiles P in Figur 8. Die in Laufrichtung vordere Kante 61 kann mit zwei über deren Oberfläche hervorstehenden Gummipuffern versehen sein.

Wenn vorgesehen ist, das Tragelement 5 wahlweise auch in Richtung des Pfeiles Q zu fördern, besitzt die Grundplatte 56 ein weitere Anschlagorgan 43', welches gleiche Gestalt und Ausführung haben kann wie die Anschlagorgane 43 und welches im Bereich der von den Seitenkanten 58 und 61 eingeschlossenen Ecke angeordnet ist. Entsprechenderweise ist dann an der gegenüberliegenden Seitenkante 63 ein weiteres Zentrierorgan 44' angeordnet, das ebenfalls einen kegeligen Oberflächenbereich 60' aufweist. Das Zentrierorgan 44 besitzt schliesslich einen gegen oben, über die Oberfläche der Grundplatte 56 vorstehenden Fortsatz 64, der mit der Klinke 45 (Figur 7) zusammenzuarbeiten bestimmt ist, indem dieser Fortsatz 64 gegen das Endstück 54 der Klinke 45 anstösst, wenn sich diese in abgesenkter Stellung befindet.

Bei einer Förderung des Tragelementes 5 in Richtung des Pfeiles dienen also einerseits die beiden Anschlagorgane 43 im Bereich der Kante 57 und anderseits das Zentrierorgan 44 im Bereich der Kante 58 als Zentriermittel, die sinngemäss einerseits mit der Anschlagfläche 41 der Zentrierbacke 18 und dem Zentrierzapfen 42 an der Zentrierbacke 19 zusammenarbeiten. Wenn hingegen das Tragelement 5 in Richtung des Pfeiles Q gefördert wird, z.B. indem es in seiner Bewegungsbahn um 90 grad umgelenkt worden ist, erfolgt die Zentrierung einerseits mit Hilfe des im Bereich der Ecke zwischen den Seitenkanten 57 und 61 angeordneten Zentrierzapfens 43 sowie des Zentrierzapfens 43', und anderseits mit Hilfe des Zentrierorganes 44', dass sich im Bereich der Seitenkanten 63 befindet. Sinngemäss arbeiten diese Zentriermittel wiederum mit einer Anschlagfläche und zwei Zentrierzapfen einer weiteren, entsprechend dimensionierten, in den Zeichnungen nicht dargestellten Zentrierstation zusammen.

Die Positioniervorrichtung arbeitet wie folgt:

Ein mit einem Werkstück 10 beladener Werkstückträger 5 wird vom Förderband 2 in der Richtung des Pfeiles I (Figuren 1 und 2) vorwärts bewegt, wobei es sich versteht, dass in den genannten Figuren lediglich ein Teilabschnitt der Förderstrecke dargestellt ist. In der Ansicht gemäss Figur 1 hat der Werkstückträger 5 im Lauf seiner Förderung einen Sensor 11 passiert, der das ordnungsgemässe Vorbeibewegen desselben registriert hat, und befindet sich in einer Warteposition, in welcher er durch die zuvor erwähnte Stauvorrichtung 12 aufgehalten, d.h. an der Weiterförderung gehindert wird. Der vorauseilende Werkstückträger 5' befindet sich bereits innerhalb der Zentrierstation 9 (Figur 2). Sobald der Werkstückträger 5' von der Zentrierstation 9 freigegeben worden ist, bewegt sich dieser weiter in Förderrichtung des Bandes 2. Die Stauvorrichtung 12 wird dann entriegelt und der in Warteposition befindliche Werkstückträger 5 fährt in die Zentrierstation 9 ein, wo er in der nachfolgend zu erläuternden Weise angehalten und zentriert wird, währenddem der Werkstückträger 5' entweder zu einer nachfolgenden Zentrierstation (nicht dargestellt) oder zu einer Entnahmestation (ebenfalls nicht dargestellt) bewegt wird. Die Sensoren 26 registrieren dabei das ordnungsgemässe Verlassen der Zentrierstation 9 durch den Werkstückträger 5'.

In der Darstellung gemäss Figur 3 ist der Werkstückträger 5 in die Zentrierstation 9 eingefahren; die Zentrierbacken 18 und 19 der Zentrierstation 9 befinden sich dabei in ihrer oberen Endlage. Damit ist Raum geschaffen, dass der Werkstückträger 5 unter die Teile 18b und 19b der Zentrierbacken 18 und 19 hineinfahren kann, ohne dass die dem Zentrierbacken 18 zugeordnete Anschlagfläche bzw. die am Zentrierbacken 19 angeordneten Zentrierzapfen 42 eine wesentliche Wirkung auf den Werkstückträger 5 ausüben.

Durch das Anheben der Zentrierbacken 18 und 19, dies unter Wirkung der pneumatischen Zylinder 28, sind ebenfalls die Gleitschuhe 25 angehoben. Ihre Oberfläche liegt dabei gegen die Unterseite des Förderbandes 2 auf und hebt dieses vom horizontal verlaufenden Quersteg des Stützorganes 3 ab. Der Werkstückträger 5 liegt somit auf der Oberfläche des Förderbandes 2 auf und ist von den Oberflächen der ortsfest angeordneten Fortsätze 27 entkoppelt. Die angehobene Endlage der Zentrierbacken 18 und 19 wird dem Steuergerät dadurch signalisiert, dass die Hülsen 36a auf den Steuerstangen 34 vor den induktiven Schaltern 37a liegen, so dass diese aktiviert sind und ein entsprechendes Signal an das Steuergerät liefern.

Die Klinke 45 (Figur 7) befindet sich zu diesem Zeitpunkt in verschwenkter Stellung, mit der Folge, dass deren Endstück 54 in die Bewegungsbahn des Werkstückträgers 5 ragt, so dass der Fortsatz 64 an der Oberseite des Zentrierorganes 44 dagegen anstossen wird; damit wird der Werkstückträger 5 an einer weiteren Fortbewegung gehindert und gleitet auf der Oberfläche des Förderbandes 2. Gleichzeitig hat der induktive Schalter 55 die Anwesenheit des Werkstückträgers 5 in der Zentrierstation 9 erkannt und meldet dies dem Steuergerät, damit der eigentliche Zentriervorgang eingeleitet werden kann.

Dazu wird zunächst einmal die Zentrierbacke 19 und kurz darauf die Zentrierbacke 18 abgesenkt. Dies bewirkt aber unter anderem, dass sich das Förderband 2 ebenfalls senkt und sich auf die Oberfläche des horizontalen Quersteges des Stützorganes 3 auflegt, währenddem die Unterseite des Werkstückträgers 5 gegen die obere Stirnfläche der Fortsätze 27 zur Auflage gelangt. Damit ist der Werkstückträger 5 vom kontinuierlich weiterlaufenden Förderband 2 entkoppelt, was eine Weiterbeförderung des Werkstückträger 5 verhindert. Nun kann auch der Zylinder 50 betätigt werden, um das Endstück 54 der Klinke 45 aus dem Bereich des Fortsatzes 64 am Zentrierorgan 44 herauszuschwenken.

Weiter bewirkt das Absenken des Zentrierbackens 19, welches, wie erwähnt, zuerst erfolgt, dass die kegeligen Oberflächen der Zentrierzapfen 42 am Teil 19b des Zentrierbackens 19 mit dem kegeligen Oberflächenteil 60 des Zentrierorganes 44 in Eingriff gelangen, wodurch zwei voneinander zu unterscheidende Verschiebungs- bzw. Zentrieroperationen eingeleitet werden:

-Zum einen wird der gesamte Werkstückträger in Figur 3 nach links verschoben, so dass dessen Anschlagorgane 43 gegen die Anschlagfläche 41 am Teil 18b der Zentrierbacke 18 anliegen.

-Zum anderen wird eine Lagepositionierung des Werkstückträgers 5 in Förderlängsrichtung in der Weise bewirkt, dass die zentrale Achse des Zentrierorganes 44 genau auf der Mittellinie zwischen den beiden Zentrierzapfen 42 liegt.

Der Werkstückträger 5 ist damit in zwei horizontalen, zueinander senkrecht verlaufenden Richtungen positioniert, nämlich in Förderrichtung des Bandes 2 und in der Richtung senkrecht dazu. Die Positionierung entlang der noch verbleibenden, dritten Achse nämlich in der vertikalen, senkrecht zum Förderband verlaufenden Achse wird dadurch erreicht, dass der auf den Fortsätzen 27 aufliegende Werkstückträger 5 einerseits vom Teil 19b der Zentrierbacke 19, unter Wirkung der Zentrierzapfen 42, und andererseits vom Teil 18b der Zentrierbacke 18 hinuntergedrückt wird. Diese Situation ist in der Figur 4 dargestellt.

Die abgesenkte Lage der beiden Zentrierbacken 18 und 19 wird dem Steuergerät dadurch gemeldet, dass sich die auf den Steuerstangen 34 befindlichen Hülsen 36a nicht mehr vor den induktiven Schaltern 37a befinden, - diese sind somit desaktiviert -, dass aber die Hülsen 36b auf den Stangen 34 in eine Position direkt vor den induktiven Schaltern 37b gelangt sind, die dadurch aktiviert werden.

In diesem Zustand verharrt die gesamte Zentrierstation 9, bis die Bearbeitung bzw. Weiterverarbeitung des auf dem Werkstückträger 5 befindlichen Werkstückes 10 abgeschlossen ist. Danach werden die beiden Zentrierbacken 18 und 19 unter Wirkung der pneumatischen Zylinder 28 in ihre obere Endlage zurückverschoben und der Werkstückträger 5 zum Weitertranspot freizugeben. Dies geschieht dadurch, dass die Gleitschuhe 25 das im Prinzip stets umlaufende Förderband 2 vom Stützorgan 3 abheben und gegen die Unterseite des Werkstückträgers 5 anpressen, der dadurch seinerseits von den Fortsätzen 27 abgehoben, vom Förderband 2 erfasst und aus der Zentrierstation 9 weggefördert wird.

Damit wiederholt sich der gesamte Zyklus insofern von Neuem, als ein nachfolgender Werkstückträger 5 von der Stauvorrichtung 12 freigegeben wird und seinerseits in die Positioniervorrichtung 9 einfahren kann; die Positionierung dieses nachfolgenden Werkstückträgers erfolgt dann in der vorher beschriebenen Weise.

Mit der vorstehend beschriebenen Vorrichtung kann eine zuverlässige, zwangsweise ablaufende Positionierung bzw. Zentrierung eines Werkstückträgers in drei zueinander senkrecht verlaufenden Achsen erfolgen, wobei zur Ausführung dieser Positionierung lediglich eine geringe Anzahl von Maschinenelementen erforderlich ist, die zudem leicht mit der erforderlichen Präzision hergestellt werden können. Dadurch, dass die Zentrierung in den zwei horizontlen Achsen im wesentlichen gleichzeitig abläuft und die Zentrierung in der dritten, vertikalen Achse durch einfaches Absenken der Zentrierbacken durchgefürt wird, ist ein ausgesprochen rascher Ablauf des gesamten Zentriervorganges gewährleistet, ohne dass in Bezug auf dessen Genauigkeit Abstriche gemacht werden müssten.

Falls im Zuge der Bearbeitung des Werkstückes 10 auf dem Werkstückträger 5 eine Umlenkung um 90 grad erforderlich ist, treten die zusätzlich an letzterem vorgesehenen Zentrierelemente in Funktion, die dann mit einer entsprechend aufgebauten, im Beispielsfalle schmaler dimensionierten Positioniervorrichtung zusammenarbeiten.

Selbstverständlich bestehen für die Ausbildung des Werkstückträgers 5 zahlreiche andere Möglichkeiten. Wesentlich ist aber, dass dieser einen mehr oder weniger plattenförmigen Unterteil aufweist, welcher mit den Anschlagorganen 43 bzw. 43' einerseits und den Zentrierorganen 44 bzw. 44' andererseits versehen werden kann. Im übrigen besteht jedwede Freiheit, den Werkstückträger entsprechend den zu bearbeitenden und demzufolge von diesem aufzunehmenden Werkstücken auszubilden.

**Patentansprüche**

1. Positioniervorrichtung für Werkstücke, die auf plattenförmigen Tragelementen (5) aufgenommen sind, mit einem Förderband, welches entlang eines Stützorganes (3) umläuft und die Tragelemente mit den Werkstücken zu einer Zentriervorrichtung (9) hin und von dieser wegbewegt, gekennzeichnet durch die folgenden Merkmale:

-das Tragelement (5, 5') für die Werkstücke (10) umfasst einen rechteckigen Teil (56) mit vier Seitenflächen (57, 58 bzw. 61, 63), wobei im Bereich einer dieser Seitenflächen (57 bzw. 61) zwei im Abstand zueinander angeordnete, über die betreffende Seitenfläche hinausragende Anschlagorgane (43 bzw. 43') und zumindest im Bereich der gegenüberliegenden Seitenfläche (58 bzw. 63) ein mit konischen Führungsflächen (60 bzw. 60') ausgerüstetes Zentrierorgan (44 bzw. 44') vorgesehen sind bzw. ist;

-die Zentrierstation (9) ist mit zumindest zwei Zentrierelementen (18, 19) ausgerüstet, wobei das erste Zentrierelement (18) eine Anschlagfläche (41) für die Anschlagorgane (43 bzw. 43') des Tragelementes (5 bzw. 5') und das zweite Zentrierelement (19) ein komplementär zum Zentrierorgan (44 bzw. 44') der Tragelemente (5 bzw. 5') gestaltetes Zentrierorgan (42) aufweist, und wobei die Zentrierelemente (18, 19) zumindest in einer senkrecht zur Bewegungsrichtung des Förderbandes (2) verlaufenden Richtung verschiebbar gelagert sind.

2. Positioniervorrichtung nach Anspruch 1, dadurch gekennzeichnet, dass der rechteckige Teil (56) im Bereich wenigstens zweier benachbarter Ecken mit Anschlagorganen (43 bzw. 43') ausgerüstet ist.

3. Positioniervorrichtung nach Anspruch 1 oder 2, dadurch gekennzeichnet, dass die Anschlagorgane (43 bzw. 43') durch zylindrische Zapfen gebildet sind, deren Mantelfläche teilweise über die Seitenkante des rechteckigen Teils (56) hinausragen.

4. Positioniervorrichtung nach einem der Ansprüche 2 oder 3, dadurch gekennzeichnet, dass der rechteckige Teil (56) im Bereich von drei Ecken mit Anschlagorganen (43 bzw. 43') ausgerüstet ist.

5. Positioniervorrichtung nach einem der Ansprüche 1 bis 3, dadurch gekennzeichnet, dass das Zentrierorgan durch einen am rechteckigen Teil (56) angebrachten, zumindest teilweise eine kegelmantelförmige Oberfläche (60 bzw. 60') aufweisenden Zentrierzapfen (44 bzw. 44') gebildet ist.

6. Positioniervorrichtung nach Anspruch 5, dadurch gekennzeichnet, dass der Zentrierzapfen (44 bzw. 44') seitlich abstehend an der Seitenfläche (58 bzw. 63) des rechteckigen Teiles (56) angebracht ist.

7. Positioniervorrichtung nach einem der vorangehenden Ansprüche, dadurch gekennzeichnet, dass zwei benachbarte Seitenflächen (58 bzw. 63) des Tragelementes (5 bzw. 5') mit je einem Zentrierorgan (44 bzw. 44') versehen sind.

8. Positioniervorrichtung nach einem oder mehreren der vorangehenden Ansprüche, dadurch gekennzeichnet, dass das bzw. die Zentrierorgane (44, 44') des Tragelementes (5, 5') jeweils in der Mitte einer Seitenfläche des rechteckigen Teils (56) des Tragelementes (5, 5') angeordnet ist bzw. sind.

9. Positioniervorrichtung nach einem oder mehreren der vorangehenden Ansprüche, dadurch gekennzeichnet, dass die Zentrierstation (9) zwei im wesentlichen parallel und im Abstand zueinander angeordnete, beidseitig des Förderbandes (2) liegende Zentrierbacken (18, 19) aufweist, die je einen ersten, sich im wesentlichen vertikal erstreckenden Teil (18a, 19a) sowie je einen zweiten, sich im wesentlichen horizontal erstreckenden, am oberen Ende des ersten Teils lösbar angebrachten Teil (18b, 19b) umfassen.

10. Positioniervorrichtung nach Anspruch 9, dadurch gekennzeichnet, dass die Zentrierstation (9) ein stationäres Gestell (6, 15) umfasst, an welchem die beiden Zentrierbacken (18, 19) in vertikaler Richtung verschiebbar gelagert sind.

11. Positioniervorrichtung nach einem der Ansprüche 9 oder 10, dadurch gekennzeichnet, dass die Anschlagfläche (41) für die Anschlagorgane (43 bzw. 43 und 43') des Tragelementes durch eine gegen das Förderband (2) gerichtete Stirnfläche des sich horizontal erstreckenden Teils (18b) des einen Zentrierbackens (18) gebildet ist.

12. Positioniervorrichtung nach einem der Ansprüche 9 bis 11, dadurch gekennzeichnet, dass der zweite Zentrierbacken (19) mit zwei an seinem sich horizontal erstreckenden Teil (19b) angebrachten, gegen unten vorstehenden, eine im wesentlichen kegelmantelförmige Oberfläche aufweisenden Zentrierzapfen (42) versehen ist.

13. Positioniervorrichtung nach einem oder mehreren der vorangehenden Ansprüche, dadurch gekennzeichnet, dass das Stützorgan (27) für das Förderband (2) im Bereich der Zentrierstation (9) mit sich längsseits des Förderbandes (2) beidseitig erstreckenden Durchbrechungen versehen ist.

14. Positioniervorrichtung nach Anspruch 13, dadurch gekennzeichnet, dass das stationäre Gestell beidseitig des Förderbandes (2) je einen im Bereich der beiden Durchbrechungen angeordneten Stützteil aufweist, dessen gegen oben gerichtete Stirnfläche eine Auflagefläche für ein Tragelement bildet.

15. Positioniervorrichtung nach Anspruch 13, dadurch gekennzeichnet, dass die beiden Zentrierbacken (18, 19) je einen im Bereich der beiden Durchbrechungen angeordneten, unter dem Förderband (2) liegenden Gleitschuh (25) aufweisen, deren obere Stirnflächen, bei einer vertikalen Verschiebung der Zentrierbacken (18, 19) gegen oben, gegen die Unterseite des Förderbandes (2) aufzuliegen und dieses von der Oberfläche dessen Stützorganes (3) abzuheben bestimmt sind.

16. Positioniervorrichtung nach einem oder mehreren der vorangehenden Ansprüche, dadurch gekennzeichnet, dass mindestens eines der beiden Zentrierelemente (18, 19) der Zentrierstation (9) mit einem Hemmorgan (45) versehen ist, welches von einer ausserhalb der Bewegungsbahn eines Tragelementes (5 bzw. 5') liegenden Ruhelage in eine in die Bewegungsbahn des Tragelementes ragende Wirklage bringbar ist.

17. Positioniervorrichtung nach Anspruch 16, dadurch gekennzeichnet, dass das Hemmorgan durch eine schwenkbar am einen Zentrierbacken (19) gelagerte, durch einen pneumatischen Zylinder (50) betätigbare Klinke (45) gebildet ist, die einerends einen in die Bewegungsbahn des Tragelementes (5 bzw. 5') verschwenkbaren Fortsatz (54) trägt.

18. Positioniervorrichtung nach einem oder mehreren der vorangehenden Ansprüche, dadurch gekennzeichnet, dass zumindest einer der Zentrierbacken (19) mit einem die Anwesenheit und/oder die Position eines Tragelementes (5 bzw. 5') zwischen den beiden Zentrierbacken (18, 19) abtastenden Schaltorgan (55), vorzugsweise einem induktiven Näherungsschalter, versehen ist.

## Claims

1. Positioning device for workpieces, which are received on plate-like carrier elements (5), with a conveyor belt revolving along a support member (3) and moving the carrier elements with the workpieces towards and away from a centring device (9), characterized by the following features:

the carrier element (5, 5') for the workpieces (10) comprises a rectangular part (56) with four sides (57, 58 or 61, 63), two spaced stop members (43, 43') being located in the vicinity of one of said sides (57 or 61) and projects over the same and in the vicinity of the facing side (58 or 63) is provided a centring member (44 or 44') equipped with conical guide faces (60 or 60'),

the centring station (9) is equipped with at least two centring elements (18, 19), the first centring element (18) having a stop face (41) for the stop members (43 or 43') of the carrier element (5 or 5') and the second centring element (19) has a centring member (42) designed in complimentary manner to the centring member (44 or 44') of carrier elements (5 or 5'), the centring elements (18, 19) being displaceably mounted at least in a direction at right angles to the direction of movement of conveyor belt (2).

2. Positioning device according to claim 1, characterized in that the rectangular part (56) is equipped with stop members (43 or 43') in the vicinity of at least two adjacent corners.

3. Positioning device according to claims 1 or 2, characterized in that the stop members (43 or 43') are formed by cylindrical lugs, whose circumferential surface partly projects over the lateral edge of rectangular part (56).

4. Positioning device according to one of the claims 2 or 3, characterized in that in the vicinity of three corners, the rectangular part (56) is equipped with stop members (43 or 43').

5. Positioning device according to one of the claims 1 to 3, characterized in that the centring member is formed by a centring pin (44 or 44') fitted to the rectangular part (56) and at least partly having a conical surface (60 or 60').

6. Positioning device according to claim 5, characterized in that the centring pin (44 or 44') is fitted in laterally projecting manner on the side (58 or 63) of rectangular part (56).

7. Positioning device according to one of the preceding claims, characterized in that two adjacent sides (58 or 63) of carrier element (5 or 5') are in each case provided with a centring member (44 or 44').

8. Positioning device according to one or more of the preceding claims, characterized in that the centring member or members (44, 44') of carrier element (5, 5') are in each case arranged in the centre of a side of the rectangular part (56) of carrier element (5, 5').

9. Positioning device according to one or more of the preceding claims, characterized in that the centring station (9) has two substantially parallel, spaced centring jaws (18, 19) positioned on either side of conveyor belt (2) in each case comprising a first, substantially vertically extending part (18a, 19a) and in each case one second, substantially horizontally extended part (18b, 19b) detachably fitted to the upper end of the first part.

10. Positioning device according to claim 9, characterized in that the centring station (9) comprises a stationary frame (6, 15), on which are displaceably vertically mounted the two centring jaws (18, 19).

11. Positioning device according to one of the claims 9 or 10, characterized in that the stop face (41) for the stop members (43 or 43 and 43') of the carrier element is formed by the face of the horizontally extending part (18b) of one centring jaw (18) directed against conveyor belt (2).

12. Positioning device according to one of the claims 9 to 11, characterized in that the second centring jaw (19) is provided with two downwardly projecting centring pins (42) having a substantially conical surface and fitted to its horizontally extending part (19b).

13. Positioning device according to one or more of the preceding claims, characterized in that the support member (27) for the conveyor belt is provided in the vicinity of centring station (9) with openings extending on either side along the conveyor belt (2).

14. Positioning device according to claim 13, characterized in that the stationary frame is provided on either side of conveyor belt (2) with a support part arranged in the vicinity of the two openings and its upwardly directed face forms a bearing face for a carrier element.

15. Positioning device according to claim 13, characterized in that the two centring jaws (18, 19) have in each case a sliding shoe (25) located below the conveyor belt (2) in the vicinity of the two openings and in the case of a vertical displacement of the centring jaws, the upper faces of said shoe bear upwards against the underside of conveyor belt (2) and are intended to raise the same from the surface of its support member (3)

16. Positioning device according to one or more of the preceding claims, characterized in that at least one of the two centring elements (18, 19) of centring station (9) is provided with an inhibiting member (45), which can be brought from an inoperative position located outside the path of movement of a carrier element (5 or 5') into an operative position projecting into the path of movement of the carrier element.

17. Positioning device according to claim 16, characterized in that the inhibiting member is formed by a latch (45) pivotably mounted on a centring jaw (19) and operable by a pneumatic cylinder (50) and carrying at one end an extension (54) pivotable into the path of movement of the carrier element (5 or 5').

18. Positioning device according to one or more of the preceding claims, characterized in that at least one of the centring jaws (19) has a switching member (55), preferably an inductive proximity switch scanning the presence and/or the position of a carrier element (5 or 5') between the two centring jaws (18, 19).

**Revendications**

1. Dispositif de positionnement pour pièces a usiner placées sur des éléments porteurs (5) en forme de plaques, comportant un tapis transporteur qui circule le long d'un organe support (3) et gui transporte les éléments porteurs comportant les pièces à usiner vers un dispositif de centrage (9), et à partir de là les amène plus loin, caractérisé par les particularités suivantes :

- l'élément porteur (5, 5') destiné aux pièces à usiner (10) comprend une partie rectangulaire (56) à quatre faces latérales (57, 58 ou 61, 63) au voisinage d'une de ces surfaces latérales (57 ou 61) étant prévus deux organes de butée (43 ou 43') disposés à une certaine distance l'un de l'autre et faisant saillie de ladite surface latérale ainsi gue, au moins au voisinage de la surface latérale opposée (58 ou 63) un organe de centrage (44 ou 44') équipé de faces de guidage coniqes (60 ou 60');

- le poste de centrage (9) est équipé d'au moins deux éléments de centrage (18, 19) le premier élément de centrage (18) présentant une face de butée (41) pour les organes de butée (43, 43') de l'élément porteur (5 ou 5'), et le deuxième élément de centrage (19) présentant un organe de centrage (42) réalisé de manière à être complémentaire à l'organe de centrage (44, 44') des éléments porteurs (5 ou 5'), les éléments de centrage (18, 19) étant positionnés de manière mobile au moins dans une direction s'étendant perpendiculairement au mouvement du tapis transporteur (2).

2. Dispositif de positionnement selon la revendication 1, caractérisé par le fait que la partie rectangulaire (56) est équipée d'organes de butée (43 ou 43') au voisinage d'au moins deux angles voisins.

3. Dispositif de positionnement selon la revendication 1 ou 2, caractérisé par le fait que les organes de butée (43 ou 43') sont constitués par des pivots cylindriques dont les surfaces latérales font saillie partiellement au-delà de l'arête latérale de la partie rectangulaire (56).

4. Dispositif de positionnement selon l'une des revendications 2 ou 3, caractérisé par le fait que la partie rectangulaire (56) est équipée d'organes de butée (43 ou 43') au voisinage de trois angles

5. Dispositif de positionnement selon l'une des revendications 1 à 3, caractérisé par le fait que l'organe de centrage est constitué par un pivot de centrage (44, 44') fixé sur la partie rectangulaire (56) et présentant au moins partiellement une surface latérale (60, 60') en forme de cône.

6. Dispositif de positionnement selon la revendication 5, caractérisé par le fait que le pivot de centrage (44 ou 44') est fixé de manière à faire saillie latéralement sur la surface latérale (58 ou 63) de la partie rectangulaire (56).

7. Dispositif de positionnement selon l'une des revendications précédentes, caractérisé par le fait que deux surfaces latérales voisines (58 ou 63) de l'élément porteur (5 ou 5') sont munis respectivement d'un organe de centrage (44 ou 44').

8. Dispositif de positionnement selon l'une ou plusieurs des revendications précédentes, caractérisé par le fait que l'élément ou les éléments de centrage (44, 44') de l'élément porteur (5, 5') sont disposés respectivement au centre d'une surface latérale de la partie rectangulaire (56) de l'élément (5, 5').

9. Dispositif de positionnement selon l'une ou plusieurs des revendications précédentes, caractérisé par le fait que le poste de centrage (9) présente deux mâchoires de centrage (18, 19) placées des deux côtés du tapis transporteur (2) et disposées sensiblement parallèlement et à une certaine distance l'une de l'autre, ces mâchoires comprenant respectivement une première partie (18a, 19a) s'étendant sensiblement verticalement ainsi qu'une deuxième partie (18b, 19b) s'étendant sensiblement horizontalement et fixées de manière amovible, sur l'extrémité supérieure de la première partie.

10. Dispositif de positionnement selon la revendication 9, caractérisé par le fait que le poste de centrage (9) comprend un châssis fixe (6, 15) sur lequel sont montées de manière mobile dans le sens vertical les deux mâchoires de centrage (18, 19).

11. Dispositif de positionnement selon l'une des revendications 9 ou 10, caractérisé par le fait que la face de butée (41) pour les organes de butée (43) ou (43 et 43') de l'élément porteur est constitué par une face frontale dirigée contre le tapis transporteur (2) de la partie (18b) s'étendant horizontalement à partir de l'une des machoîres de centrage (18).

12. Dispositif de positionnement selon l'une des revendications 9 à 11, caractérisé par le fait que la deuxième mâchoire de centrage (19) est munie de deux pivots de centrage (42) fixés sur sa partie (19b) s'étendant horizontalement, faisant saillie vers le bas, et présentant une surface ayant sensiblement la forme d'une enveloppe conique.

13. Dispositif de positionnement selon l'une ou plusieurs des revendications précédentes, caractérisé par le fait que l'organe de support (27) pour le tapis transporteur (2) est muni au voisinage du poste de centrage (9) d'interruptions s'étendant des deux côtés longitudinalement au tapis transporteur (2).

14. Dispositif de positionnement selon la revendication 13, caractérisé par le fait que le châssis fixe présente des deux côtés du tapis transporteur (2) respectivement une partie support disposée au voisinage des interruptions, la surface frontale orientée vers le haut de cette partie support formant une surface d'appui pour un élément porteur.

15. Dispositif de positionnement selon la revendication 13, caractérisé par le fait que les deux mâchoires de centrage (18, 19) présentent respectivement un sabot (25) situé dans la zone des deux interruptions, sous le tapis transporteur (2), sabot dont les surfaces frontales supérieures, lors d'un déplacement vertical des mâchoires (18, 19) en direction du haut, sont destinées à s'appuyer contre le côté inférieur du tapis transporteur (2) et à soulever celui-ci de la surface de son organe support (3).

16. Dispositif de positionnement selon l'une ou plusieurs des revendications précédentes, caractérisé par le fait qu'au moins l'un des deux éléments de centrage (18, 19) du poste de centrage (9) est muni d'un organe de blocage (45) gui peut être amené à partir d'une position passive située extérieurement à la voie de déplacement d'un élément porteur (5 ou 5') dans une position active pénétrant dans la voie de déplacement dudit élément porteur.

17. Dispositif de positionnement selon la revendication 16, caractérisé par le fait que l'organe de blocage est constitué par un cliquet (45) placé de manière pivotable sur une mâchoire de centrage (19) et pouvant être actionné par un cylindre pneumatique (50), cliquet gui supporte sur une extrémité un appendice (54) pouvant basculer dans la voie de déplacement de l'élément porteur (5 ou 5').

18. Dispositif de positionnement selon l'une ou plusieurs des revendications précédentes, caractérisé par le fait qu'au moins l'une des mâchoires de centrage (19) est munie d'un organe de commande (55) détectant la présence et/ou la position d'un élément porteur (5 ou 5') entre les deux mâchoires de centrage (18, 19), cet organe étant de préférence un détecteur d'approche par induction.

FIG. 1

FIG. 2

0183117

FIG. 3

FIG. 4

FIG. 5

FIG. 6

FIG. 8

FIG. 9

FIG. 10

FIG. 7